Europäisches Patentamt

European Patent Office

Office européen des brevets

(19)

(11)     EP 0 866 974 B1

(12)                EUROPÄISCHE PATENTSCHRIFT

(45) Veröffentlichungstag und Bekanntmachung des
Hinweises auf die Patenterteilung:
**08.03.2000   Patentblatt 2000/10**

(51) Int Cl.[7]: **G01R 15/24**

(21) Anmeldenummer: **96945760.5**

(22) Anmeldetag: **02.12.1996**

(86) Internationale Anmeldenummer:
**PCT/DE96/02311**

(87) Internationale Veröffentlichungsnummer:
**WO 97/22883 (26.06.1997 Gazette 1997/27)**

(54) **OPTISCHES MESSVERFAHREN UND OPTISCHE MESSANORDNUNG ZUM MESSEN EINER WECHSELGRÖSSE MIT INTENSITÄTSNORMIERUNG**

OPTICAL MEASURING PROCESS AND OPTICAL MEASURING ARRANGEMENT FOR MEASURING AN ALTERNATING QUANTITY WITH INTENSITY SCALING

PROCEDE ET DISPOSITIF DE MESURE OPTIQUE POUR MESURER UNE GRANDEUR ALTERNATIVE AVEC MISE A L'ECHELLE DE L'INTENSITE

(84) Benannte Vertragsstaaten:
**CH DE FR GB IT LI**

(30) Priorität: **15.12.1995   DE 19547021**

(43) Veröffentlichungstag der Anmeldung:
**30.09.1998   Patentblatt 1998/40**

(73) Patentinhaber: **SIEMENS
AKTIENGESELLSCHAFT
80333 München (DE)**

(72) Erfinder:
• **WILLSCH, Michael
D-90762 Fürth (DE)**
• **BOSSELMANN, Thomas
D-91054 Erlangen (DE)**
• **MENKE, Peter
D-91054 Erlangen (DE)**
• **HAIN, Stefan
D-91090 Effeltrich (DE)**

(56) Entgegenhaltungen:
WO-A-95/10046                US-A- 4 973 899

• **PATENT ABSTRACTS OF JAPAN vol. 14, no. 381
(P-1093), 16.August 1990 & JP 02 143173 A
(HITACHI), 1.Juni 1990,**

**Beschreibung**

Die Erfindung betrifft ein Verfahren und eine Anordnung zum Messen eines Wechselgröße. Unter einer Wechselgröße wird dabei und im folgenden eine Meßgröße verstanden, die in ihrem Frequenzspektrum nur von Null verschiedene Frequenzanteile aufweist und somit insbesondere eine zeitlich veränderliche Meßgröße ist.

Die US-A-4 973 899 zeigt als nächstliegender Stand der Technik ein solches Verfahren und eine solche Anordnung.

Aus *WO 95/10046* sind optische Meßanordnungen und Meßverfahren zum Messen einer Wechselgröße, insbesondere zum Messen eines magnetischen Wechselfeldes oder eines elektrischen Wechselstromes unter Ausnutzung des magnetooptischen Faraday-Effekts oder zum Messen eines elektrischen Wechselfeldes oder einer elektrischen Wechselspannung unter Ausnutzung des elektrooptischen Pockels-Effekts bekannt. In eine unter dem Einfluß der Wechselgröße stehende Sensoreinrichtung wird polarisiertes Meßlicht eingekoppelt. Die Polarisation des Meßlichts wird in der Sensoreinrichtung in Abhängigkeit von der Wechselgröße geändert. Zur Analyse dieser Polarisationsänderung wird das Meßlicht nach wenigstens einmaligem Durchlaufen der Sensoreinrichtung in zwei linear polarisierte Lichtteilsignale mit unterschiedlichen Polarisationsebenen aufgeteilt. Es wird ein intensitätsnormiertes Signal P gebildet, das dem Quotienten aus einer Differenz und der Summe der Lichtintensitäten der beiden Lichtteilsignale entspricht. Aus einem Wechselsignalanteil und einem Gleichsignalanteil des intensitätsnormierten Signals wird ein temperaturkompensiertes Meßsignal hergeleitet. Der Gleichsignalanteil enthält dabei keine Frequenzanteile der Wechselgröße und wird nur zur Temperaturkompensation verwendet.

Aus der Firmenschrift *"Optical Combined Current & voltage H.V. Sensors, GEC Alsthom, T*&D ist ein magnetooptischer Stromwandler bekannt, bei dem ein in einem Polarisator linear polarisiertes Lichtsignal einen Faraday-Glasring durchläuft und danach von einem polarisierenden Strahlteiler in zwei senkrecht zueinander linear polarisierte Lichtteilsignale aufgespalten wird (zweikanalige Polarisationsauswertung). Beide Lichtteilsignale werden über jeweils eine Lichtleitfaser einer zugehörigen Photodiode zugeführt, die das entsprechende Lichtteilsignal in ein elektrisches Intensitätssignal S1 oder S2 umwandelt, das proportional zur Lichtintensität des zugehörigen Lichtteilsignals ist. Aufgrund unterschiedlicher Dämpfung in den beiden Lichtleitfasern können nun die beiden Proportionalitätskonstanten verschieden voneinander sein. Zum Ausgleich dieser Empfindlichkeitsunterschiede ist eine besondere Regelung vorgesehen. Ein der ersten Photodiode nachgeschalteter steuerbarer erster Verstärker verstärkt das Intensitätssignal S1 um einen zugehörigen Verstärkungsfaktor K1 und ein der zweiten Photodiode nachgeschalteter zweiter Verstärker das zweite Intensitätsignal S2 um einen zweiten Verstärkungsfaktor K2. Es werden nun Gleichsignalanteile (DC values) der beiden Intensitätssignale S1 und S2 bestimmt und die Differenz der beiden Gleichsignalanteile wird als Regelgröße auf Null geregelt durch Steuern des Verstärkungsfaktors K1 des ersten Verstärkers. Aus den beiden im allgemeinen unterschiedlich stark verstärkten Intensitätssignale K1·S1 und K2·S2 an den Ausgängen der beiden Verstärker wird nun ein Meßsignal gebildet, das dem Quotienten (K1·S1 - K2·S2)/( K1·S1 + K2·S2) aus der Differenz und der Summe der Ausgangssignale der Verstärker entspricht.

Der Erfindung liegt die Aufgabe zugrunde, ein optisches Meßverfahren und eine optische Meßanordnung zum Messen einer Wechselgröße anzugeben, bei denen der Polarisationszustand von polarisiertem Meßlicht in einer Sensoreinrichtung in Abhängigkeit von der Wechselgröße geändert wird und das Meßlicht zum Auswerten dieser Polarisationsänderung nach wenigstens einmaligem Durchlaufen in zwei unterschiedlich linear polarisierte Lichtteilsignale aufgeteilt wird und unerwünschte Intensitätsänderungen in den Lichtwegen des Meßlichts und der beiden Lichtteilsignale kompensiert werden.

Diese Aufgabe wird gemäß der Erfindung gelöst mit den Merkmalen des Anspruchs 1 bzw. des Anspruchs 4.

Das Verfahren zum Messen einer Wechselgröße gemäß der Erfindung umfaßt folgende Verfahrensschritte:

a) polarisiertes Meßlicht eine unter dem Einfluß der Wechselgröße stehende Sensoreinrichtung, die die Polarisation des Meßlichts in Abhängigkeit von der Wechselgröße ändert, wenigstens einmal durchläuft und danach in zwei linear polarisierte Lichtteilsignale mit unterschiedlichen Polarisationsebenen aufgeteilt wird und

b) aus Lichtintensitäten I1 und I2 eines ersten bzw. zweiten der beiden Lichtteilsignale und Gleichanteilen $I1_{DC}$ bzw. $I2_{DC}$ dieser beiden Lichtintensitäten I1 bzw. I2 jeweils entsprechende, proportionale elektrische Intensitätssignale erzeugt werden,

c) aus diesen elektrischen Intensitätssignalen ein Meßsignal für die Wechselgröße gebildet wird, das proportional zum Quotienten

$$(I2_{DC} \cdot I1 - I1_{DC} \cdot I2) / (I2_{DC} \cdot I1 + I1_{DC} \cdot I2)$$

d) ist, wobei die beiden Gleichanteile $I1_{DC}$ bzw. $I2_{DC}$ keine Frequenzanteile der Wechselgröße enthalten.

Die Anordnung zum Messen einer Wechselgröße gemäß der Erfindung enthält

a) einer Sensoreinrichtung, die die Polarisation von polarisiertem Licht in Abhängigkeit von der Wechselgröße ändert,

b) Mittel zum Einkoppeln von polarisiertem Meßlicht in die Sensoreinrichtung,

c) Mittel zum Aufteilen des Meßlichts nach wenigstens einmaligem Durchlaufen der Sensoreinrichtung in zwei linear polarisierte Lichtteilsignale mit unterschiedlichen Polarisationsebenen,

d) Mittel zum Bilden von elektrischen Intensitätssignalen, die jeweils proportional zu Lichtintensitäten I1 bzw. I2 einer ersten bzw. eines zweiten der beiden Lichtteilsignale und zu Gleichanteilen $I1_{DC}$ bzw. $I2_{DC}$ dieser beiden Lichtintensitäten I1 bzw. I2 sind, wobei die Gleichanteile $I1_{DC}$ bzw. $I2_{DC}$ keine Frequenzanteile der Wechselgröße enthalten,

e) Mittel zum Bilden eines Meßsignals für die Wechselgröße aus den elektrischen Intensitätssignalen, wobei das Meßsignal proportional zum Quotienten

$(I2_{DC} \cdot I1 - I1_{DC} \cdot I2) / (I2_{DC} \cdot I1 + I1_{DC} \cdot I2)$ ist.

Das Meßsignal ist durch die besondere Berücksichtigung der Gleichsignalanteile $I1_{DC}$ und $I2_{DC}$ der beiden Lichtintensitäten I1 bzw. I2 als Maß für die genannten Intensitätsänderungen in den Lichtwegen praktisch vollständig intensitätsnormiert.

Vorteilhafte Ausgestaltungen und Weiterbildungen des Verfahrens und der Anordnung gemäß der Erfindung ergeben sich aus den jeweils abhängigen Ansprüchen.

Demnach werden das Verfahren und die Anordnung in einer ersten vorteilhaften Ausführungsform vorzugsweise zum Messen eines magnetischen Wechselfeldes eingesetzt, indem eine den magnetooptischen Faraday-Effekt zeigende Sensoreinrichtung verwendet wird und das Meßsignal als Maß für das magnetische Wechselfeld herangezogen wird.

In einer zweiten vorteilhaften Ausführungsform werden das Verfahren und die Anordnung zum Messen einer elektrischen Wechselspannung oder eines elektrischen Wechselfeldes eingesetzt, indem eine den elektrooptischen Pockels-Effekt zeigende Sensoreinrichtung verwendet wird und das Meßsignal als Maß für die elektrische Wechselspannung oder das elektrische Wechselfeld herangezogen wird.

Die beiden Lichtteilsignale werden vorzugsweise jeweils über wenigstens eine Lichtleitfaser und insbesondere über jeweils wenigstens zwei Lichtleitfasern und eine optische Steckverbindung zum lösbaren Verbinden der beiden Lichtleitfasern übertragen. Die Steckverbindungen sind vorteilhaft zum vorübergehenden Trennen der im allgemeinen auf unterschiedlichen elektrischen Potentialen liegenden Sensoreinrichtung einerseits und der Auswerteelektronik andererseits. Das Meßsignal ist in dieser Ausführungsform auch unabhängig von Änderungen der Lichtintensitäten der beiden Lichtteilsignale durch Änderungen der Dämpfungseigenschaften der Steckverbindungen nach deren Öffnen und darauffolgendem Schließen.

Zur weiteren Erläuterung der Erfindung wird auf die Zeichnung Bezug genommen, in deren

FIG 1    ein Ausführungsbeispiel einer Meßanordnung zum Messen eines magnetischen Wechselfeldes, insbesondere des magnetischen Wechselfeldes eines elektrischen Wechselstromes und

FIG 2    ein Ausführungsbeispiel einer Meßanordnung zum Messen einer elektrischen Wechselspannung

jeweils schematisch dargestellt sind. Einander entsprechende Teile sind mit denselben Bezugszeichen versehen.

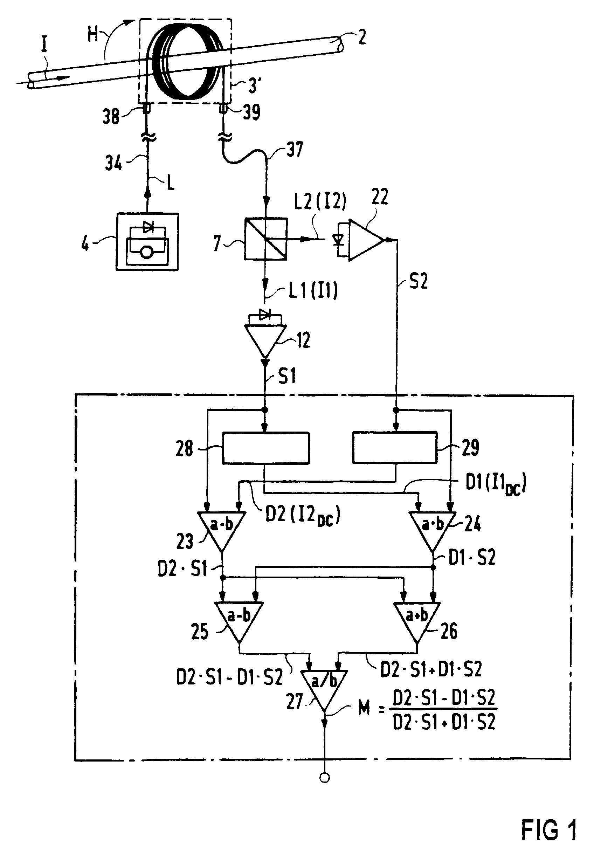

In FIG 1 ist eine optische Meßanordnung zum Messen eines magnetischen Wechselfeldes **H**, insbesondere zum Messen eines elektrischen Wechselstromes I in einem Stromleiter 2, dargestellt. Im magnetischen Wechselfeld **H** ist eine Faraday-Sensoreinrichtung 3 zugeordnet. Die Sensoreinrichtung 3 ist mit einem Lichtleiter, vorzugsweise einer optischen Faser, gebildet, der den Stromleiter 2 in einer Meßwicklung mit wenigstens einer Meßwindung umgibt und den magnetooptischen Faraday-Effekt aufweist. Als Faraday-Sensoreinrichtung 3 können jedoch auch ein oder mehrere massive Körper aus einem Faraday-Material, der bzw. die einen vorzugsweise den Stromleiter 2 umgebenden Lichtpfad bilden, vorgesehen sein, vorzugsweise ein Glasring. Die Faraday-Sensoreinrichtung 3 muß den Stromleiter 2 auch nicht in einem geschlossenen Lichtpfad umgeben, sondern kann auch nur in räumliche Nähe neben dem Stromleiter 2 im Magnetfeld **H** des Wechselstromes I angeordnet sein.

Linear polarisiertes Meßlicht L wird vorzugsweise über einen polarisationserhaltenden Lichtleiter 34 in die Sensoreinrichtung 3 eingekoppelt. Zum Erzeugen dieses linear polarisierten Meßlichts L können eine Lichtquelle und zugeordnete, nicht dargestellte polarisierende Mittel oder auch eine selbst polarisierende Lichtquelle 4, beispielsweise eine Laserdiode, und gegebenenfalls zusätzliche, nicht dargestellte polarisierende Mittel vorgesehen sein. Das linear polarisierte Meßlicht L durchläuft die Sensoreinrichtung 3 wenigstens einmal und erfährt dabei eine von dem magnetischen Wechselfeld **H** bzw. dem elektrischen Wechselstrom I abhängige Faraday-Drehung ρ seiner Polarisationsebene. Nach dem Durchlaufen der Sensoreinrichtung 3 wird das Meßlicht L einem Analysator 7 zugeführt und im Analysator 7 in zwei linear polarisierte Lichtteilsignale L1 und L2 zerlegt, deren Polarisationsebenen verschieden voneinander sind. Vorzugsweise sind die Polarisationsebenen der beiden Lichtteilsignale Ll und L2 senkrecht zueinander gerichtet (orthogonale Zerlegung). Als Analysator 7 können ein polarisierender Strahlteiler, beispielsweise ein Wollaston-Prisma, oder auch ein einfacher Strahlteiler mit einem teildurchlässigen Spiegel mit zwei optisch nachgeschalteten und um einen entsprechenden Winkel und vorzugsweise um 90° gekreuzte Polarisationsfilter und vorgesehen sein. Die Sensoreinrichtung 3 und der Analysator 7 können über eine Freistrahlanordnung oder auch über einen polarisationserhaltenden Lichtleiter 37, vorzugsweise eine Monomode-Lichtfaser wie beispielsweise eine HiBi(High Birefringence)-Faser oder eine polarisationsneutrale LoBi(Low Birefringence)-Faser, optisch miteinander verbunden sein. Der Lichtleiter der Sensoreinrichtung 3 ist mit dem Lichtleiter 34 zum Zuführen des Meßlichts L und mit dem Lichtleiter 37 zum Abführen des Meßlichts L vorzugsweise jeweils über einen Spleiß 35 bzw. 39 verbunden.

In einer nicht dargestellten Ausführungsform wird das Meßlicht L nach einem ersten Durchlauf in die Faraday-Sensoreinrichtung 3 zurückreflektiert und durchläuft die Faraday-Sensoreinrichtung 3 ein zweites Mal in umgekehrter Richtung (Reflexionstyp), bevor es in die Lichtteilsignale L1 und L2 aufgeteilt wird.

Die beiden Lichtteilsignale L1 und L2 werden jeweils einem photoelektrischen Wandler 12 bzw. 22 zugeführt, vorzugsweise jeweils einer in einen Verstärkerkreis geschalteten Photodiode. Die Übertragung der beiden Lichtteilsignale L1 und L2 vom Analysator 7 zu dem jeweiligen Wandler 12 bzw. 22 kann wie dargestellt über eine Freistrahlanordnung oder über jeweils einen Lichtleiter erfolgen. Der erste photoelektrische Wandler 12 wandelt das erste Lichtsignal L1 in ein erstes elektrisches Intensitätssignal S1 um, das im wesentlichen proportional zur Lichtintensität I1 des ersten Lichtsignals L1 ist, also S1 = K1·I1. Der zweite photoelektrische Wandler 22 wandelt das zweite Lichtsignal L2 in ein zweites elektrisches Intensitätssignal S2 um, das im wesentlichen proportional zur Lichtintensität I2 des zweiten Lichtsignals L2 ist, also S2 = K2·I2. Die Proportionalitätsfaktoren K1 und K2 dieser Umwandlungen sind von den photoelektrischen Wirkungsgraden und den anschließenden Verstärkungen der Signale in den Wandlern 21 und 22 bestimmt und können sich aufgrund von Störeinflüssen auch mit der Zeit ändern.

Die Auswertung der beiden Intensitätssignale S1 und S2 in einer Auswerteeinheit 20 geschieht nun vorzugsweise folgendermaßen. Jedes der beiden elektrischen Intensitätssignale S1 und S2 wird einem Eingang eines zugehörigen ersten Multiplizieres 23 bzw. zweiten Multiplizierers 24 und einem Eingang eines zugehörigen ersten Filters 28 bzw. zweiten Filters 29 mit Tiefpaßcharakter zugeführt. Das erste Filter 28 bildet einen Gleichsignalanteil D1 des ersten Intensitätssignals S1, der dem K1-fachen Gleichanteil $I1_{DC}$ der Lichtintensität I1 des ersten Lichtsignals L1 entspricht, also D1 = K1·$I1_{DC}$. Der an einem Ausgang des Filters 28 anstehende Gleichsignalanteil D1 des ersten Intensitätssignals S1 wird einem zweiten Eingang des ersten Multiplizierers 23 zugeführt. Das zweite Filter 29 bildet einen Gleichsignalanteil D2 des zweiten Intensitätssignals S2, der dem K2-fachen Gleichanteil $I2_{DC}$ der Lichtintensität I2 des zweiten Lichtsignals L2 entspricht, also D2 = K2·$I2_{DC}$. Der an einem Ausgang des zweiten Filters 29 anstehende Gleichsignalanteil D2 des zweiten Intensitätssignals S2 wird einem zweiten Eingang des zweiten Multiplizierers 24 zugeführt. Als Filter 28 und 29 können beispielsweise analoge oder digitale Tiefpaßfilter eingesetzt werden, deren Trennfrequenzen jeweils unterhalb der tiefsten Frequenz im Spektrum der Wechselgröße, in der dargestellten Ausführungsform also des magnetischen Wechselfeldes H oder des elektrischen Wechselstromes I, eingestellt werden. Die beiden Gleichsignalanteile D1 und D2 und somit auch die beiden Gleichlichtanteile $I1_{DC}$ und $I2_{DC}$ enthalten deshalb keine Informationen über die Wechselgröße (insbesondere das magnetische Wechselfeld **H**), jedoch gerade die Informationen über eine unerwünschte Arbeitspunktdrift der beiden Lichtintensitäten I1 und I2. Diese Informationen über eine Intensitätsdrift werden nun wie folgt für die Herleitung eines intensitätsnormierten Meßsignals verwendet. Der erste Multiplizierer 23 bildet das Produkt D2·S1 des ersten Intensitätssignals S1 und des Gleichsignalanteils D2 des zweiten Intensitätssignals S2. Der zweite Multiplizierer 24 bildet das Produkt D1·S2 des Gleichsignalanteils D1 des ersten Intensitätssignals S1 und des zweiten Intensitätssignals S2. Diese beiden Produkte D2·S1 und D1·S2 werden nun von dem Ausgang des entsprechenden Multiplizierers 23 bzw. 24 jeweils einem Eingang eines Subtrahierers 25 und jeweils einem Eingang eines Addierers 26 zugeführt. Das vom Subtrahierer 25 gebildete Differenzsignal D2·S1-D1·S2 der beiden Produktsignale D2·S1 und D1·S2 wird an einen ersten Eingang eines Dividierers 27 angelegt. Am zweiten Eingang des Dividierers 27 liegt das vom Addierer 26 gebildete Summensignal D2·S1+D1·S2 der beiden Produkte D2·S1 und D1·S2 an. An einem Ausgang des Dividierers 27 kann nun das Meßsignal

$$M = (D2·S1 - D1·S2)/(D2·S1 + D1·S2) \tag{1}$$

für das magnetische Wechselfeld **H** bzw. für den elektrischen Wechselstrom I abgegriffen werden, das dem Quotientensignal aus der Differenz D2·S1-D1·S2 und der Summe D2·I1+D1·I2 entspricht.

In einer nicht dargestellten, abgewandelten Ausführungsform der Signalauswertung in der Auswerteeinheit 20 wird zunächst ein Quotient der beiden Gleichsignalanteile D1 und D2 als Korrekturfaktor K = D1/D2 ermittelt. Mit diesem Korrekturfaktor K wird ein Meßsignal

$$M' = (S1 - K · S2)/( S1 + K · S2) \tag{2}$$

gebildet.

Die beiden Meßsignale M gemäß Gleichung (1) und M' gemäß Gleichung (2) sind beide gleich dem direkt aus den Lichtintensitäten I1 und I2 und deren Gleichanteilen $I1_{DC}$ und $I2_{DC}$ gebildeten Quotienten:

$$M = M' = (I1 \cdot I2_{DC} - I2 \cdot I1_{DC})/(I1 \cdot I2_{DC} + I2 \cdot I1_{DC}) \qquad (3)$$

Die Empfindlichkeiten K1 und K2 der beiden Wandler 12 und 22 fallen bei der Bildung des Meßsignals M gemäß Gleichung (1) oder des Meßsignals M' gemäß Gleichung (2) somit heraus.

Ein Vorteil der dargestellten Ausführungsform der Auswerteeinheit 20 mit analogen arithmetischen Bausteinen ist die schnelle Signalverarbeitung. Natürlich kann das Meßsignal M oder M' auch mit Hilfe einer Wertetabelle und/ oder mit Hilfe von digitalen Bausteinen ermittelt werden.

Das gemäß einer der Gleichungen (1) bis (3) ermittelte Meßsignal M bzw. M' ist ferner praktisch vollständig intensitätsnormiert. Das bedeutet, daß sich unerwünschte Änderungen der Lichtintensitäten I1 und I2 der beiden Lichtteilsignale L1 und L2 aufgrund von Übertragungsverlusten nicht mehr auf das Meßsignal M oder M' auswirken.

Aus dem Meßsignal M oder M' kann nun der elektrische Wechselstrom I im Stromleiter 2 mit Hilfe der Beziehung $\rho = N \, V \, I$ mit der Verdet-Konstanten V des Faraday-Effekts in der Sensoreinrichtung 3 und der Zahl N der Umläufe des Meßlichts L um den Stromleiter 2 ermittelt werden.

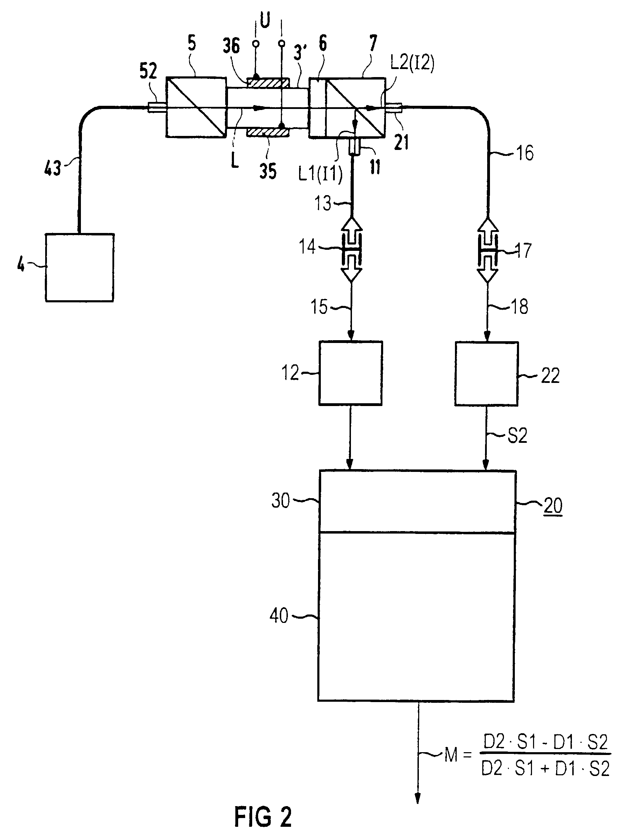

FIG 2 zeigt eine Ausführungsform einer optischen Meßanordnung zum Messen einer elektrischen Wechselspannung U als Wechselgröße X mit einem einen den elektrooptischen Pockels-Effekt zeigenden Sensoreinrichtung 3. Die zu messende Wechselspannung U ist über zwei Elektroden 35 und 36 an die Pockels-Sensoreinrichtung 3' anlegbar. In die Pockels-Sensoreinrichtung 3' wird polarisiertes Meßlicht L eingekoppelt. Dieses Meßlicht L durchläuft die Pockels-Sensoreinrichtung 3' und erfährt dabei eine von der angelegten Wechselspannung U abhängige Änderung seiner Polarisation. Die Wechselspannung U wird in der dargestellten Ausführungsform senkrecht zur Lichtausbreitungsrichtung des Meßlichts L angelegt (transversale Ausführungsform), kann aber auch parallel zur Lichtausbreitungsrichtung angelegt werden (longitudinale Ausführungsform). Als Mittel zum Einkoppeln des Meßlichtes L in die Sensoreinrichtung 3' sind eine Lichtquelle 4, beispielsweise eine Leuchtdiode, und ein Polarisator 5 zum linearen Polarisieren des Lichts der Lichtquelle 4 vorgesehen. Die Lichtquelle 4 und der Polarisator 5 sind vorzugsweise über einen Lichtleiter 43, beispielsweise eine Multimode-Lichtfaser, optisch miteinander verbunden, können aber auch durch eine Freistrahlkopplung optisch miteinander gekoppelt sein. Zum Einkoppeln des Lichts aus dem Lichtleiter 43 in den Polarisator 5 ist vorzugsweise eine Kollimatorlinse (Grin lens) 25 vorgesehen. Aus dem Polarisator 5 wird das nun linear polarisierte Meßlicht L in die Pockels-Sensoreinrichtung 3' eingekoppelt. Nach Durchlaufen der Pockels-Sensoreinrichtung 3 wird das Meßlicht L über ein $\lambda/4$-Plättchen 6 dem Analysator 7 zugeführt. In dem Analysator 7 wird das Meßlicht L in zwei linear polarisierte Lichtteilsignale L1 und L2 zerlegt, deren Polarisationsebenen verschieden voneinander sind. Vorzugsweise sind die Polarisationsebenen der beiden Lichtteilsignale L1 und L2 senkrecht zueinander gerichtet (orthogonale Zerlegung). Als Analysator 7 können ein polarisierender Strahlteiler, beispielsweise ein Wollaston-Prisma, oder auch zwei um einen vorgegebenen Winkel, vorzugsweise 90°, gekreuzte Polarisationsfilter und ein vorgeschalteter einfacher Strahlteiler vorgesehen sein.

Der Arbeitspunkt der Meßanordnung gemäß FIG 2 wird vorzugsweise so eingestellt, daß am Analysator 7 zirkular polarisiertes Meßlicht anliegt, wenn an der Pockels-Sensoreinrichtung 3' kein elektrisches Feld anliegt. Die beiden Eigenachsen der linearen Doppelbrechung in der Pockels-Sensoreinrichtung 3' sind in diesem Fall vom Meßlicht L "gleichmäßig ausgeleuchtet". Das bedeutet, daß die auf die beiden Eigenachsen projizierten Komponenten des Meßlichts L jeweils die gleiche Intensität aufweisen. Im allgemeinen sind dann die beiden Lichtteilsignale L1 und L2 ebenfalls gleich stark in ihrer Intensität. Bei Anlegen einer Wechselspannung ($U \neq 0$ V) an die Pockels-Sensoreinrichtung 3' werden die Komponenten des Meßlichts L entlang der elektrooptisch aktiven Eigenachsen der linearen Doppelbrechung der Pockels-Sensoreinrichtung 3' in ihrer Intensität in Abhängigkeit von der Wechselspannung U geändert.

Anstelle der in FIG 2 dargestellten optischen Reihenschaltung des Polarisators 5, der Pockels-Sensoreinrichtung 3', des $\lambda/4$-Plättchens 6 und des Analysators 7 kann auch eine optische Reihenschaltung aus dem Polarisator 5, dem $\lambda/4$-Plättchen 6, der Pockels-Sensoreinrichtung 3' und dem Analysator 7 vorgesehen sein, also die Reihenfolge des $\lambda/4$-Plättchens 6 und der Sensoreinrichtung 3' gerade vertauscht sein. In diesem Fall wird das Meßlicht L vor dem Einkoppeln in die Pockels-Sensoreinrichtung 3' zirkular polarisiert. Außerdem kann anstelle der Lichtquelle 4 und des Polarisators 5 auch eine Lichtquelle zum Senden linear polarisierten Lichts wie beispielsweise eine Laserdiode vorgesehen sein zum Einkoppeln von polarisiertem Meßlicht L in die Sensoreinrichtung 3' bzw. das $\lambda/4$-Plättchen 6. Der Lichtleiter 43 ist dann vorzugsweise ein polarisationserhaltender Lichtleiter. Die Übertragung der Lichtteilsignale L1 bzw. L2 kann ferner auch in einer Freistrahlanordnung erfolgen. Der Analysator 7 kann überdies mit dem $\lambda/4$-Plättchen 6 bzw. der Pockels-Sensoreinrichtung 3' über einen polarisationserhaltenden Lichtleiter optisch verbunden sein.

Die beiden Lichtteilsignale L1 und L2 werden vorzugsweise über jeweils eine Kollimatorlinse 11 bzw. 21 in jeweils einen Lichtleiter 13 bzw. 16 eingekoppelt. Jeder Lichtleiter 13 und 16 ist über jeweils eine optische Steckverbindung 14 bzw. 17 mit jeweils einem weiteren Lichtleiter 15 bzw. 18 verbunden. Durch die Steckverbindungen 14 und 17 ist die Sensoreinrichtung 3 von der Auswerteeinheit 20 trennbar. Die beiden Lichtteilsignale L1 und L2 werden nun über die zugehörige Steckverbindung 14 bzw. 17 und den zugehörigen weiteren Lichtleiter 15 bzw. 18 eingekoppelt. Nach Durchlaufen der Pockels-Sensoreinrichtung 3 wird das Meßlicht L über ein λ/4-Plättchen 6 dem Analysator 7 zugeführt. In dem Analysator 7 wird das Meßlicht L in zwei linear polarisierte Lichtteilsignale L1 und L2 zerlegt, deren Polarisationsebenen verschieden voneinander sind. Vorzugsweise sind die Polarisationsebenen der beiden Lichtteilsignale Ll und L2 senkrecht zueinander gerichtet (orthogonale Zerlegung). Als Analysator 7 können ein polarisierender Strahlteiler, beispielsweise ein Wollaston-Prisma, oder auch zwei um einen vorgegebenen Winkel, vorzugsweise 90°, gekreuzte Polarisationsfilter und ein einfacher Strahlteiler vorgesehen sein. Die Steckverbindungen können auch bei allen anderen Ausführungsformen der Meßanordnung, insbesondere der in FIG 1 dargestellten, vorgesehen sein.

Die beiden elektrischen Intensitätssignale S1 und S2 werden mit Hilfe des Analog/Digital-Wandlers 30 digitalisiert und die digitalisierten Signale werden von einem Mikroprozessor oder einem digitalen Signalprozessor 40 zum Bilden eines Meßsignal M gemäß Gleichung (1) oder M' gemäß Gleichung (2) weiterverarbeitet. Der Analog/Digital-Wandler 30 und der Prozessor 40 bilden dann die Auswerteeinheit 20. Der Prozessor 40 führt die Filterung der Gleichsignalanteile D1 und D2 digital aus und berechnet dann das Meßsignal M oder M' nach Gleichung (1) bzw. (2) .

## Patentansprüche

1. Verfahren zum Messen einer Wechselgröße ($H$,U), bei dem

   a) polarisiertes Meßlicht (L) eine unter dem Einfluß der Wechselgröße ($H$,U) stehende Sensoreinrichtung (3), die die Polarisation des Meßlichts (L) in Abhängigkeit von der Wechselgröße ($H$,U) ändert, wenigstens einmal durchläuft und danach in zwei linear polarisierte Lichtteilsignale (L1,L2) mit unterschiedlichen Polarisationsebenen aufgeteilt wird und

   b) aus Lichtintensitäten (I1 und I2) eines ersten bzw. zweiten der beiden Lichtteilsignale (L1,L2) und Gleichanteilen ($I1_{DC}$ bzw. $I2_{DC}$) dieser beiden Lichtintensitäten (I1 bzw. I2) jeweils entsprechende, proportionale elektrische Intensitätssignale (S1,D1 bzw. S2,D2) erzeugt werden,

   c) aus diesen elektrischen Intensitätssignalen (S1,D1 bzw. S2,D2) ein Meßsignal (M) für die Wechselgröße (H,U) gebildet wird, das proportional zum Quotienten

   $(I2_{DC} \cdot I1 - I1_{DC} \cdot I2) / (I2_{DC} \cdot I1 + I1_{DC} \cdot I2)$

   d) ist, wobei die beiden Gleichanteile $I1_{DC}$ bzw. $I2_{DC}$ keine Frequenzanteile der Wechselgröße ($H$,U) enthalten.

2. Verfahren nach Anspruch 1 zum Messen eines magnetischen Wechselfeldes ($H$), bei dem eine den Faraday-Effekt zeigende Sensoreinrichtung (3) verwendet wird und das Meßsignal (M) als Maß für das magnetische Wechselfeld (H) herangezogen wird.

3. Verfahren nach Anspruch 1 zum Messen einer elektrischen Wechselspannung (U) oder eines elektrischen Wechselfeldes, bei dem eine den Pockels-Effekt zeigende Sensoreinrichtung (3') verwendet wird und das Meßsignal (M') als Maß für die elektrische Wechselspannung (U) oder das elektrische Wechselfeld herangezogen wird.

4. Anordnung zum Messen einer Wechselgröße ($H$,U) mit

   a) einer Sensoreinrichtung (3,3'), die die Polarisation von polarisiertem Licht in Abhängigkeit von der Wechselgröße ($H$,U) ändert,

   b) Mitteln (10,11,12,13) zum Einkoppeln von polarisiertem Meßlicht (L) in die Sensoreinrichtung (3),

   c) Mitteln (7) zum Aufteilen des Meßlichts (L) nach wenigstens einmaligem Durchlaufen der Sensoreinrichtung (3) in zwei linear polarisierte Lichtteilsignale (L1,L2) mit unterschiedlichen Polarisationsebenen,

   d) Mitteln (12, 22, 28, 29) zum Bilden von elektrischen Intensitätssignalen (S1,D1 bzw. S2,D2), die jeweils proportional zu Lichtintensitäten (I1 bzw. I2) einer ersten bzw. eines zweiten der beiden Lichtteilsignale (L1 bzw. L2) und zu Gleichanteilen ($I1_{DC}$ bzw. $I2_{DC}$) dieser beiden Lichtintensitäten (I1 bzw. I2) sind, wobei die Gleichanteile ($I1_{DC}$ bzw. $I2_{DC}$) keine Frequenzanteile der Wechselgröße ($H$,U) enthalten,

   e) Mitteln (23, 24, 25, 26, 27) zum Bilden eines Meßsignals (M) für die Wechselgröße ($H$,U) aus den elektrischen Intensitätssignalen (S1,D1,S2,D2), wobei das Meßsignal (M) proportional zum Quotienten

   $(I2_{DC} \cdot I1 - I1_{DC} \cdot I2) / (I2_{DC} \cdot I1 + I1_{DC} \cdot I2)$ ist.

**5.** Anordnung nach Anspruch 4 zum Messen eines magnetischen Wechselfeldes (**H**), bei der die Sensoreinrichtung (3) den magnetooptischen Faraday-Effekt zeigt.

**6.** Anordnung nach Anspruch 4 zum Messen einer elektrischen Wechselspannung (U) oder eines elektrischen Wechselfeldes, bei der die Sensoreinrichtung (3') den elektrooptischen Pockels-Effekt zeigt.

**7.** Anordnung nach einem der Ansprüche 4 bis 6 mit jeweils wenigstens einer Lichtleitfaser (13, 16) zum Übertragen der beiden Lichtteilsignale (L1,L2).

**8.** Anordnung nach Anspruch 7, die zum Übertragen der beiden Lichtteilsignale (L1,L2) jeweils wenigstens zwei Lichtleitfasern (13, 16 bzw. 15, 18) und eine optische Steckverbindung (14, 17) zum lösbaren Verbinden der beiden Lichtleitfasern (13, 16 bzw. 15, 18) umfaßt.

**Claims**

**1.** Process for measuring a periodic quantity (H,U), in which

a) polarized measuring light (L) traverses at least once a sensor device (3) which is under the influence of the periodic quantity (H,U) and which varies the polarization of the measuring light (L) as a function of the periodic quantity (H,U), and thereafter is split into two linearly polarized component light signals (L1,L2) with different planes of polarization, and
b) respectively corresponding, proportional electric intensity signals (S1, D1 and S2, D2, respectively) are produced from light intensities (I1 and I2) of a first and, respectively, second of the two component light signals (L1,L2) and direct components ($I1_{DC}$ and $I2_{DC}$, respectively), of these two light intensities (I1 and I2, respectively),
c) a measuring signal (M) for the periodic quantity (H,U) which is proportional to the quotient $(I2_{DC} \cdot I1 - I1_{DC} \cdot I2) / (I2_{DC} \cdot I1 + I1_{DC} \cdot I2)$ is formed from these electric intensity signals (S1, D1 and S2, D2, respectively) the two direct components $I1_{DC}$ and $I2_{DC}$, respectively, containing no frequency components of the periodic quantity (H,U).

**2.** Method according to Claim 1 for measuring an alternating magnetic field (H), in which a sensor device (3) exhibiting the Faraday effect is used, and the measuring signal (M) is used as a measure of the alternating magnetic field (H).

**3.** Method according to Claim 1 for measuring an alternating electric voltage (U) or an alternating electric field, in which a sensor device (3') exhibiting the Pockels effect is used, and the measuring signal (M') is used as a measure of the alternating electric voltage (U) or of the alternating electric field.

**4.** Arrangement for measuring a periodic quantity (H,U) having

a) a sensor device (3,3') which varies the polarization of polarized light as a function of the periodic quantity (H,U),
b) means (10,11,12,13) for launching polarized measuring light (L) into the sensor device (3),
c) means (7) for splitting the measuring light (L) after at least once traversing the sensor device (3) into two linearly polarized component light signals (L1,L2) with different planes of polarization,
d) means (12,22,28,29) for forming electric intensity signals (S1, D1 and S2, D2, respectively) which are in each case proportional to light intensities (I1 and I2, respectively) of a first and, respectively, second of the two component light signals (L1 and L2, respectively) and to direct components ($I1_{DC}$ and $I2_{DC}$, respectively) of these two light intensities (I1 and I2, respectively), the direct components ($I1_{DC}$ and $I2_{DC}$, respectively) containing no frequency components of the periodic quantity (H,U),
e) means (23,24,25,26,27) for forming a measuring signal (M) for the periodic quantity (H,U) from the electric intensity signals (S1, D1 S2, D2), the measuring signal (M) being proportional to the quotient $(I2_{DC} \cdot I1 - I1_{DC} \cdot I2) / (I2_{DC} \cdot I1 + I1_{DC} \cdot I2)$.

**5.** Arrangement according to Claim 4 for measuring an alternating magnetic field (H), in which the sensor device (3) exhibits the magnetooptic Faraday effect.

**6.** Arrangement according to Claim 4 for measuring an alternating electric voltage (U) or an alternating electric field, in which the sensor device (3') exhibits the electrooptic Pockels effect.

7. Arrangement according to one of Claims 4 to 6, having in each case at least one optical fibre (13,16) for transmitting the two component light signals (L1,L2).

8. Arrangement according to Claim 7, which for the purpose of transmitting the two component light signals (L1,L2) comprises in each case at least two optical fibres (13,16 and 15,18, respectively), and a demountable optical connection (14,17) for detachably connecting the two optical fibres (13,16 and 15,18 respectively).

## Revendications

1. Procédé pour mesurer une grandeur (H, U) alternative, dans lequel

   a) de la lumière (L) de mesure polarisée passe au moins une fois dans un dispositif (3) capteur qui est soumis à l'influence de la grandeur (H, U) alternative et qui modifie la polarisation de la lumière (L) de mesure en fonction de la grandeur (H, U) alternative, et est ensuite subdivisée en deux sous-signaux (L1, L2) lumineux à polarisation linéaire dont les plans de polarisation sont différents, et
   b) on produit à partir d'intensités (11 et 12) lumineuses d'un premier et d'un deuxième des deux sous-signaux (L1, L2) lumineux et à partir de composantes ($I1_{DC}$ et $I2_{DC}$) continues de ces deux intensités (11 et 12) lumineuses respectivement des signaux (S1, D1 et S2, D2) électriques d'intensité correspondants proportionnels,
   c) on forme à partir de ces signaux (S1, D1 et S2, D2) électriques d'intensité un signal (M) de mesure pour la grandeur (H, U) alternative, qui est proportionnel au quotient :
   $(I2_{DC} \cdot I1 - I1_{DC} \cdot I2)/(I2_{DC} \cdot I1 + I1_{DC} \cdot I2)$
   d) les deux composantes $I1_{DC}$ et $I2_{DC}$ continues ne contenant pas de composante de fréquence de la grandeur (H, U) alternative.

2. Procédé suivant la revendication 1 pour mesurer un champ (H) magnétique alternatif, dans lequel on utilise un dispositif (3) capteur présentant l'effet Faraday et dans lequel on tire parti du signal (M) de mesure comme mesure du champ (H) magnétique alternatif.

3. Procédé suivant la revendication 1 pour mesurer une tension (U) électrique alternative ou un champ électrique alternatif, dans lequel on utilise un dispositif (3') capteur présentant l'effet Pockel et dans lequel on tire parti du signal (M') de mesure comme mesure de la tension (U) électrique alternative ou du champ électrique alternatif.

4. Dispositif pour mesurer une grandeur (H, U) alternative comportant

   a) un dispositif (3, 3') capteur qui modifie la polarisation de lumière polarisée en fonction de la grandeur (H, U) alternative,
   b) des moyens (10, 11, 12, 13) pour injecter de la lumière (L) de mesure polarisée dans le dispositif (3) capteur,
   c) des moyens (7) pour subdiviser la lumière (L) de mesure après au moins un passage dans le dispositif (3) capteur en deux sous-signaux (L1, L2) lumineux à polarisation linéaire ayant des plans de polarisation différents,
   d) des moyens (12, 22, 28, 29) pour former des signaux (S1, D1 et S2, D2) électriques d'intensité, qui sont proportionnels chacun à des intensités (11 et 12) lumineuses d'un premier et d'un deuxième des deux sous-signaux (L1 et L2) lumineux et à des composantes ($I1_{DC}$ et $I2_{DC}$) continues de ces deux intensités (11 et 12) lumineuses, les composantes ($I1_{DC}$ et $I2_{DC}$) continues ne contenant pas de composante de fréquence de la grandeur (H, U) alternative,
   e) des moyens (23, 24, 25, 26, 27) pour former un signal (M) de mesure pour la grandeur (H, U) alternative à partir des signaux (S1, D1, S2, D2) électriques d'intensité, le signal (M) de mesure étant proportionnel au quotient :
   $(I2_{DC} \cdot I1 - I1_{DC} \cdot I2)/(I2_{DC} \cdot I1 + I1_{DC} \cdot I2)$

5. Dispositif suivant la revendication 4 pour mesurer un champ (H) magnétique alternatif, dans lequel le dispositif (3) capteur présente l'effet magnéto-optique de Faraday.

6. Dispositif suivant la revendication 4 pour mesurer une tension (U) électrique alternative ou un champ électrique alternatif, dans lequel le dispositif (3') de capteur présente l'effet électro-optique de Pockel.

**7.** Dispositif suivant l'une des revendications 4 à 6, comportant respectivement au moins une fibre (13, 16) guide de lumière pour transmettre les sous-signaux (L1, L2) lumineux.

**8.** Dispositif suivant la revendication 7 qui comprend pour la transmission des deux sous-signaux (L1, L2) lumineux respectivement au moins deux fibres (13, 16 et 15, 18) guides de lumière et une liaison (14, 17) optique à enfichage pour relier de manière amovible les deux fibres (13, 16 et 15, 18) de guide de lumière.

FIG 1

FIG 2

$$M = \frac{D2 \cdot S1 - D1 \cdot S2}{D2 \cdot S1 + D1 \cdot S2}$$